Europäisches Patentamt

European Patent Office

Office européen des brevets

(11) Publication number: **0 414 013 A2**

# EUROPEAN PATENT APPLICATION

(21) Application number: 90114950.0

(22) Date of filing: 03.08.90

(51) Int. Cl.5: **H01L 21/82**, H01L 27/06

(30) Priority: 23.08.89 US 398353

(43) Date of publication of application:
27.02.91 Bulletin 91/09

(84) Designated Contracting States:
DE FR GB IT NL

(71) Applicant: TEXAS INSTRUMENTS
INCORPORATED
13500 North Central Expressway
Dallas Texas 75265(US)

(72) Inventor: Eklund, Robert H.
1121 Joshua Tree Drive
Plano, Texas 75023(US)
Inventor: Havemann, Robert H.
7413 Stillwater Ct.
Garland, Texas 75042(US)

(74) Representative: Leiser, Gottfried, Dipl.-Ing. et al
Patentanwälte Prinz, Leiser, Bunke & Partner
Manzingerweg 7
D-8000 München 60(DE)

(54) Method for forming bipolar transistor in conjunction with complementary metal oxide semiconductor transistors.

(57) The described embodiments of the present invention provide a method and structure for incorporating a bipolar transistor into a complementary metal oxide semiconductor integrated circuit. The bipolar transistor is formed using a minimum of additional steps above those required for forming the complementary MOS integrated circuitry.

*Fig. 1A* PRIOR ART

# METHOD FOR FORMING BIPOLAR TRANSISTOR IN CONJUNCTION WITH COMPLEMENTARY METAL OXIDE SEMICONDUCTOR TRANSISTORS

## FIELD OF THE INVENTION

The present invention relates to the field of integrated circuit fabrication. More specifically, the present invention relates to the field of incorporating bipolar transistors with complementary metal oxide semiconductor transistors in a single integrated circuit.

## BACKGROUND OF THE INVENTION

In traditional integrated circuit fabrication, integrated circuits were composed of one basic transistor type. For example, bipolar integrated circuits generally have only bipolar transistors in the circuit, and metal oxide semiconductor (MOS) integrated circuits generally only have MOS transistors in the integrated circuit. MOS transistors and particularly complementary MOS integrated circuits (CMOS), where N-channel and P-channel transistors are combined, are desirable for their efficient power use. On the other hand, bipolar transistors can operate at much higher speeds.

Recently, integrated circuits have been developed using bipolar and metal oxide semiconductor transistors in the same integrated circuit (BiCMOS), thus combining the speed advantages of bipolar transistors with the power savings associated with complementary metal oxide semiconductor transistors. Several circuits are on the market using these techniques. However, the inclusion of both types of transistors in one circuit provides a great deal of process complexity. Additional process complex ity leads to higher manufacturing costs and lower yield. Both of these factors drive up the cost of manufacturing BiCMOS integrated circuits.

## SUMMARY OF THE THE INVENTION

The described embodiments of the present invention provide a method and structure for incorporating a bipolar transistor into a complementary metal oxide semiconductor integrated circuit. The bipolar transistor is formed using a minimum of additional steps above those required for forming the complementary MOS integrated circuitry.

One embodiment of the invention is a method for forming a bipolar transistor, comprising the steps of:
providing a substrate having a first conductivity type;
forming a buried doped region in the substrate having a second conductivity type opposite to the first conductive type, the buried region being spaced from a surface of the substrate;
forming a contact to the buried doped region;
forming and patterning a layer on the surface;
forming an emitter doped region in the substrate adjacent to the layer using the layer as a mask to prevent forming the emitter doped region under the patterned layer; and
forming a contact to the substrate adjacent to the layer.

Another embodiment of the invention is a method for forming a bipolar transistor, comprising the steps of:
providing a substrate having a first conductivity type;
forming a buried doped region in the substrate having a second conductivity type opposite to the first conductive type, the buried region being spaced from a surface of the substrate;
forming a trench from the surface to the buried doped region;
forming sidewall insulating layers on the sidewalls of the trench;
filling the trench with a conductive material;
forming and patterning a layer on the surface;
forming an emitter doped region in the substrate adjacent to the layer using the layer as a mask to prevent forming the emitter doped region under the patterned layer; and
forming a contact to the substrate adjacent to the layer.

## DESCRIPTION OF THE DRAWINGS

The invention may be best understood in the form of the specific embodiments described in the following detailed description in conjunction with the drawings wherein:

Figures 1A through 15A are side view schematic diagrams depicting the processing steps necessary to fabricate a BiCMOS integrated circuit using prior techniques;

Figures 7B through 9B and 12B through 15B are side view schematic diagrams depicting the processing steps used for fabricating one embodiment of the present invention which are numerically coordinated with Figures 1A through 15A to show the correlation between the embodiment described in Figures 7B through 9B and 12B through 15B and the steps shown in Figures 1A through 15A;

Figure 16 is a side view schematic diagram depicting another embodiment of the present invention; and

Figures 17A through 17E are side view schematic diagrams depicting the processing steps for fabricating another embodiment of the present invention.

## DETAILED DESCRIPTION

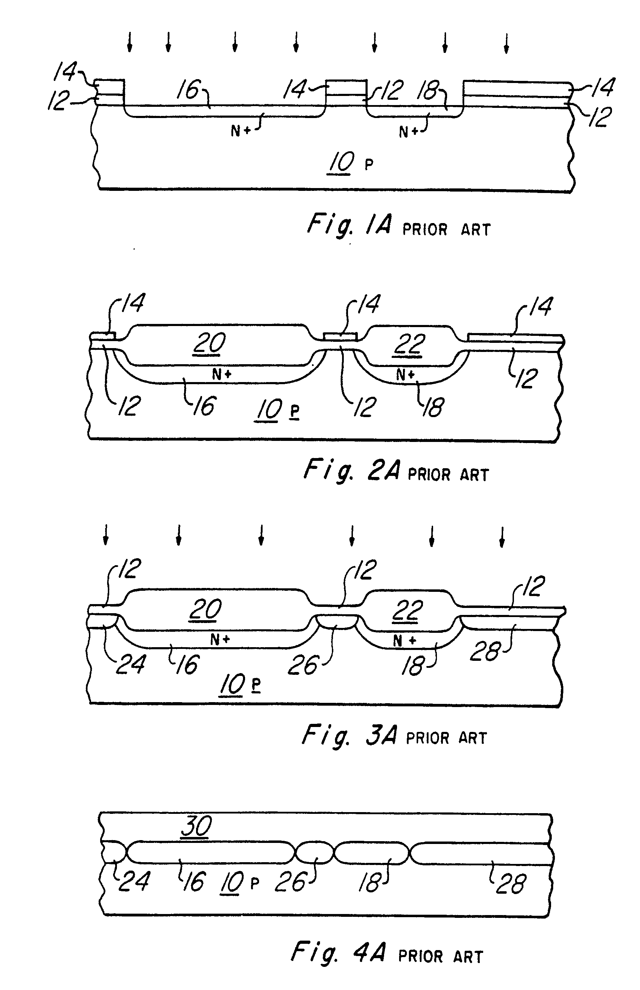

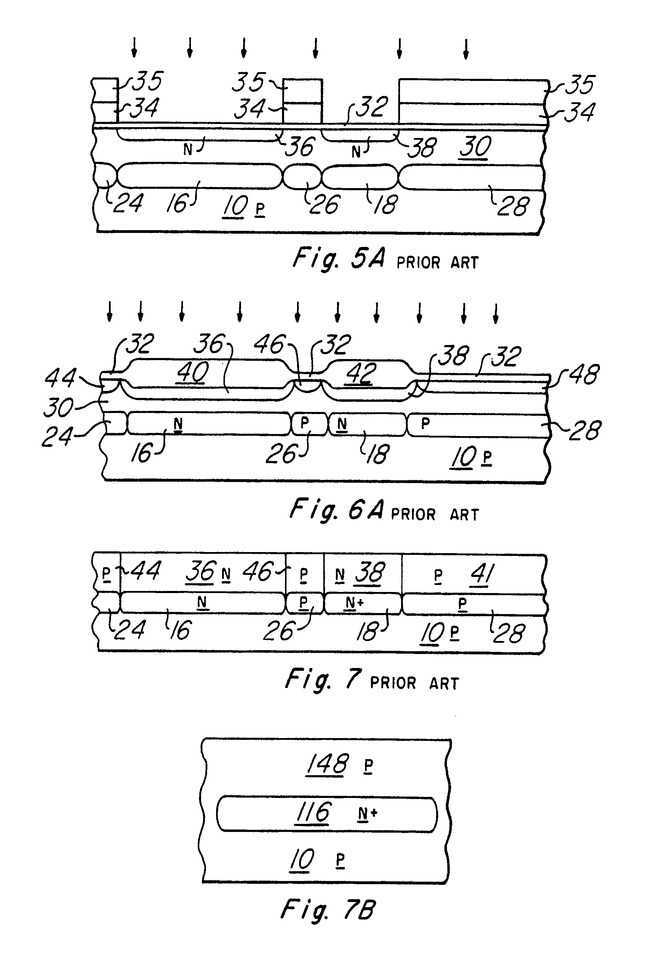

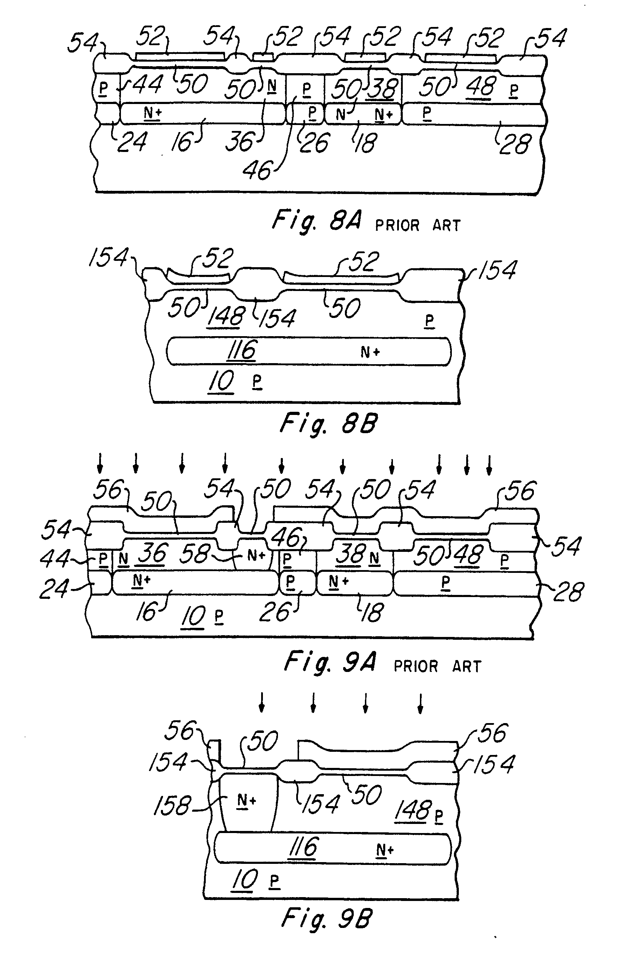

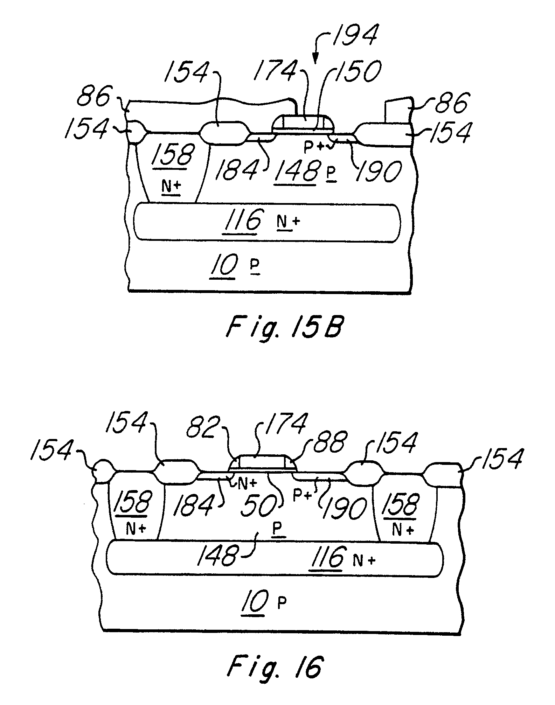

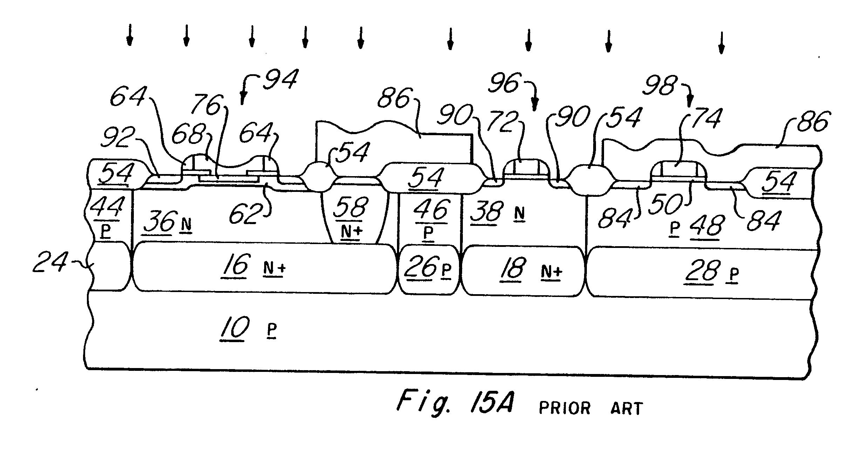

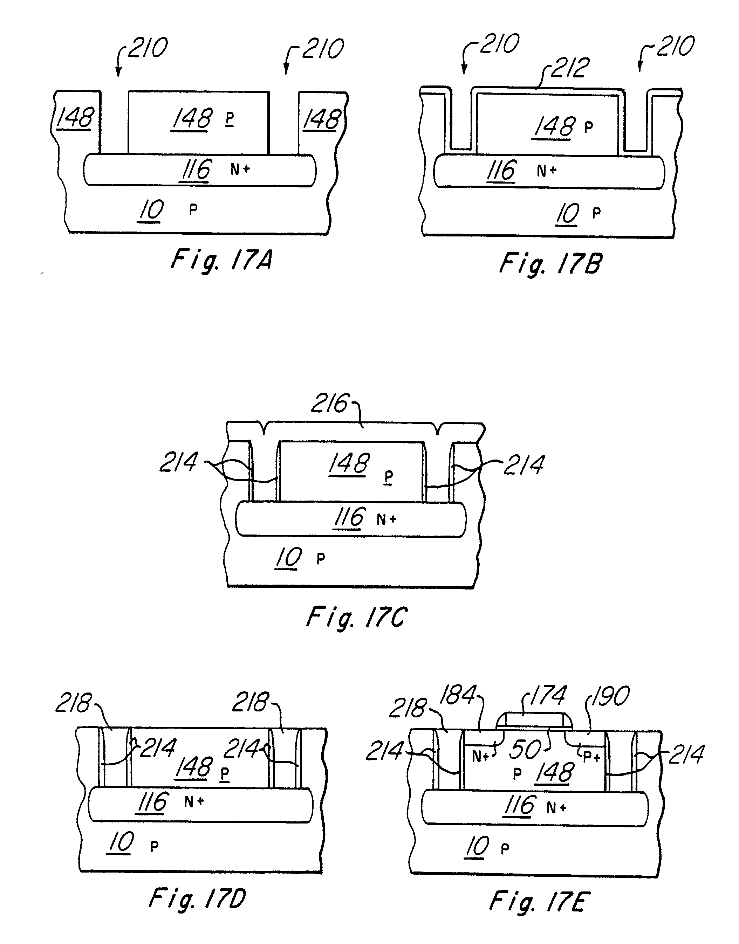

Figures 1A through 15A are side-view schematic diagrams of a prior process for fabricating BiCMOS devices. Figures 7B through 9B and 12B through 15B are side view schematic diagrams of one embodiment of the invention. The "B" figures are coordinated with the "A", figures in the process flow. For example, the same processing steps (e.g. oxidation, ion implantation, etc.) used to make the structures of Figure 8A are used to make the structures of Figure 8B. Figures 16 and 17A through 17E depict alternative embodiments of the invention.

Referring to Figure 1A, the starting material for the described fabrication processes is 100 oriented crystalline silicon doped P type to a resistivity of 8-15 ohms/square. This is substrate 10 as shown in Figure 1A. A layer of silicon dioxide 12 is formed on the surface of substrate 10 by thermal oxidation in a steam ambient at a temperature of approximately 900°C for approximately 15.5 minutes. A layer of silicon nitride is then formed on the top of silicon dioxide layer 12 using low pressure chemical vapor deposition to a thickness of approximately 1,000 Angstroms. Silicon dioxide layer 12 and silicon nitride layer 14 are then patterned using common photolithographic techniques to provide the structure shown in Figure 1A. The structure of Figure 1A is then subjected to an ion implantation of N type ions such as Antimony ions having an energy of approximately 40 to 60 kiloelectron volts at a density of approximately $3 \times 10^{15}$ ions/$cm^2$. This ion implantation provides N type regions 16 and 18 as shown in Figure 1A. The structure of Figure 1A is then subjected to thermal oxidation in a $N_2O_2$ ambient for approximately 30 minutes at a temperature of approximately 1250°C. This oxidation step provides thick oxide regions 20 and 22 as shown in Figure 2A. In addition, N+ doped region 16 and 18 are driven into substrate 10 and annealed.

Silicon nitride layer 14 is then removed using phosphoric acid. The remaining structure, as shown in Figure 3A is then subjected to an ion implantation of boron ions having an energy of approximately 70 kiloelectron volts and a density of approximately $1 \times 10^{13}$ ions/$cm^2$. This ion implantation forms P regions 24, 26 and 28 as shown in Figure 3A. Silicon dioxide layer 12 and silicon dioxide regions 20 and 22 are then removed using buffered hydrofluoric acid. An intrinsic silicon epitaxial layer is then formed on the surface of substrate 10. The remaining structure is shown in Figure 4A. Intrinsic crystalline silicon layer 30 is formed by this epitaxial process.

Another process for forming buried doped regions 16, 18, 24, 26 and 28 providing higher planarity and an improved structure may be found in copending application, Serial Number 265,074 filed October 31, 1988 and assigned to the assignee of this application. Serial Number 265,074 is hereby incorporated by reference.

Silicon dioxide layer 32 is formed on the surface of the structure of Figure 4A by thermal oxidation in an oxygen ambient for approximately 50 minutes at a temperature of approximately 950°C. This structure is shown in Figure 5A. Silicon nitride layer 34 is then formed to a thickness of approximately 1,000 to 1,400 Angstroms using low pressure chemical vapor deposition. Photoresist layer 35 is then formed and patterned using common photolithographic techniques to provide the structure as shown in Figure 5A. Photoresist layer 35 is then used as a mask to etch silicon nitride layer 34 using phosphoric acid. The structure of Figure 5A is then subjected to a double ion implantation of phosphorus ions having an energy of approximately 320 kiloelectron volts, and then 70 kiloelectron volts both at a density of approximately $1 \times 10^{12}$ ions/$cm^2$. This ion implantation forms N regions 36 and 38 as shown in Figure 5A.

Photoresist layer 34 is removed and the structure of Figure 5A is then subjected to thermal oxidation in a steam ambient for approximately 190 minutes at approximately 900°C. This forms thick oxide regions 40 and 42 as shown in Figure 6A. Silicon nitride layer 34 is then removed using phosphoric acid. The structure of Figure 6A is then subjected to an ion implantation of boron ions having an energy of approximately 50 Kiloelectron volts and a density of approximately $1 \times 10^{12}$ ions/$cm^2$. This ion implantation forms P regions 44, 46 and 48 as shown in Figure 6A. Diffusions 36, 38, 44, 46, and 48 are driven in using an annealing step at a temperature of approximately 1,000°C for approximately 150 minutes in a nitrogen ambient. The resulting structure is shown in Figure 7A. The structure of Figure 7B is formed using the processing steps described with regard to Figures 1A through 7A.

A thin silicon dioxide layer is then grown on the surface of the structure of Figure 7A using thermal oxidation in an oxygen ambient at approximately 850°C for approximately 51.5 minutes. This forms silicon dioxide layer 50 as shown in Figure 8A. A layer of silicon nitride 52 is formed on the surface of silicon dioxide layer 50 and patterned to provide the structure shown in Figure 8A. This structure is then subjected to a thermal oxidation step in a high pressure (10 atmospheres) steam ambient at approximately 975°C for approximately 20 minutes to form silicon dioxide regions 54 to a thickness of approximately 8,000 Angstroms as shown in Figure 8A. In a preferred embodiment, a layer of polycrystalline silicon (not shown) is formed on silicon dioxide layer 50. Silicon nitride layer 52 is then formed on the polycrystalline silicon layer. As silicon dioxide regions 54 are formed, the polycrystalline layer is oxidized. The polycrystalline silicon layer serves as a buffer to minimize crystal defects caused by formation of silicon dioxide regions 54. This process is more fully explained in Havemann, et al., U.S. Patent No. 4,541,167, entitled "Method for Integrated Circuit Device Isolation", issued September 17, 1985 and assigned to the assignee of this application. This patent is hereby incorporated by reference. Silicon nitride layer 52 is also formed as shown in Figure 8B and isolation regions 154 are fabricated using the same processing step used to fabricate silicon dioxide regions 54 in Figure 8A.

Silicon nitride layer 52 is removed using wet chemical etching in phosphoric acid. A layer of photoresist 56 is then formed on the surface of the structure of Figure 8 as shown in Figure 9A. Photoresist layer 56 is selected to a thickness of approximately 18,000 Angstroms to provide a thick ion implantation mask for the implantation of phosphorus ions at an energy of approximately 150 kiloelectron volts having a density of approximately $1 \times 10^{16}$ atoms/$cm^2$. This ion implantation forms, when annealed, N+ contact region 58 as shown in Figure 9A. Masking layer 56 is formed as shown in Figure 9B and N+ region 158 is formed using the implantation step used to form N+ region 58 in Figure 9A.

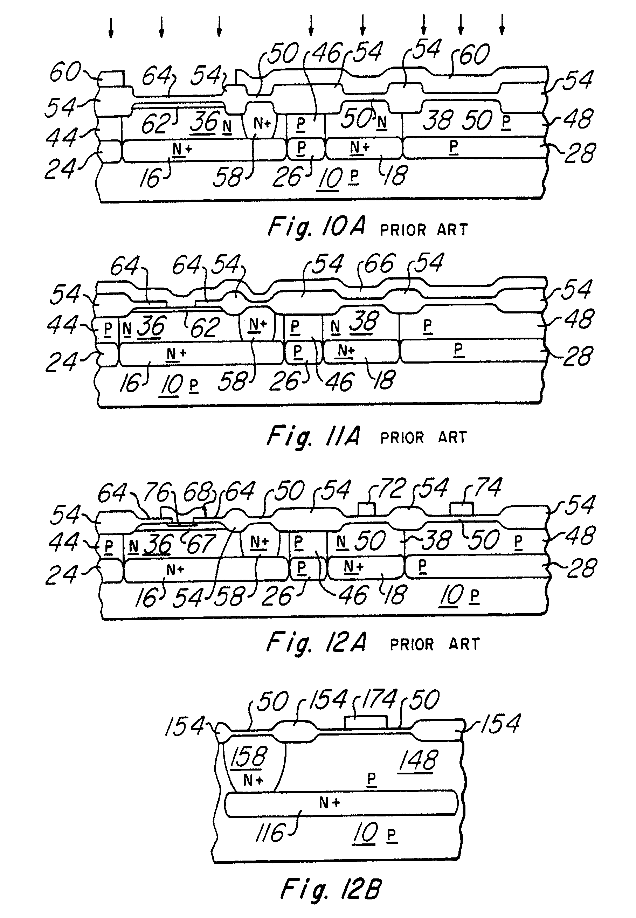

Photoresist layer 56 is then removed using common ashing and liquid removal techniques Silicon nitride layer 60 is then formed on the surface of the structure of Figure 9A as shown in Figure 10A. Silicon nitride layer 60 is patterned and etched to expose the surface of silicon dioxide layer 50 above N well 36. The exposed portions of silicon dioxide layer 50 are then removed using wet etching in hydrofluoric acid. Silicon dioxide layer 64 is then grown using thermal oxidation at a temperature of approximately 900° in a steam atmosphere for approximately 59 minutes. Silicon dioxide layer 64 is grown to a thickness of approximately 1,400 Angstroms which is much thicker than the 200 Angstrom thickness of silicon dioxide layers 50. This structure is subjected to an ion implantation of boron ions having a density of approximately $5.8 \times 10^{13}$ ions/$cm^2$ and an energy of approximately 40 kiloelectron volts which forms P region 62.

Silicon nitride layer 60 is then removed using wet chemical etching in phosphoric acid. A first polycrystalline silicon layer (not shown) is then deposited using low pressure chemical vapor deposition to a thickness of approximately 2,000 Angstroms. A photomask (not shown) is then formed and patterned. The photomask (not shown) is then used to pattern the first polycrystalline silicon layer (not shown) and silicon dioxide layer 64 as shown in Figure 11A. The photomask (not shown) is then removed and a second layer of polycrystalline silicon layer is deposited to a thickness of 2500 Angstroms to form combined polycrystalline silicon layer 66 is formed on the surface of the structure of Figure 11A. Polycrystalline silicon layer 66 is doped to N++ type using one of several optional techniques, such as ion implantation, in situ doping, or any other suitable technique. Polycrystalline silicon layer 66 is then patterned to provide emitter contact 68 collector contact 70, gate 72 and gate 74 as shown in Figure 12A. In the process, a portion of the doping from polycrystalline silicon layer 66 diffuses into the surface of substrate 10 at P region 62 to form N++ emitter 76. The steps of Figures 10A and 11A are omitted in fabricating the transistor fabricated in Figures 12B through 15B. Thus, the transistor fabricated in Figures 7B through 9B and 12B through 15B uses less complex processing allowing for less expensive manufacturing and higher yield. Polycrystalline silicon layers 170 and 174 are formed using the same step used to form polycrystalline silicon layers 68, 70, 72, and 74.

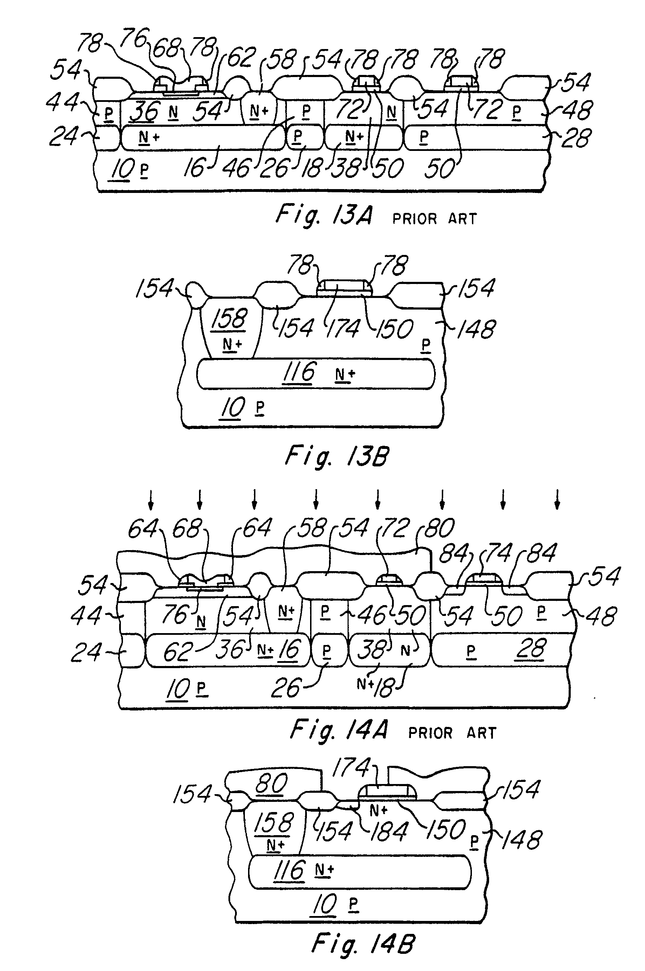

A layer of silicon dioxide (not shown) is then formed on the surface of the structure of Figure 12A, to a thickness of approximately 1,000 Angstroms using chemical vapor deposition. This silicon dioxide layer is then etched anisotropically using reactive ion etching in $CHF_3$. This leaves silicon dioxide sidewall layers 78 as shown in Figure 12 A. In subsequent figures, reference numerals to silicon dioxide sidewall layers are omitted for clarity of the figures. Silicon dioxide sidewall layers 78 are also formed on the structure of Figure 12B to provide the structure shown in Figure 13B. A suitable etching mask 80, comprising material such as patterned photoresist, is formed on the surface of silicon dioxide layer 78. Etch mask 80 and silicon dioxide layer 78 are patterned and etched to expose the portion of the surface of P well 48 which is not covered by gate 74. The removal of etch mask 80 and silicon dioxide layer 78 is conducted by anisotropic etching using reactive ion etching. Thus, a portion of silicon dioxide layer 78 will remain as sidewall oxide layers 82. A two step ion implantation of arsenic and phosphorus ions is then performed with the Arsenic ions having aD energy of 150 kiloelectron volts and a density of approximately $3 \times 10^{15}$ ions/$cm^2$ and the phosphorous ions having an energy of 85 kiloelectron volts and a density of $4 \times 10^{15}$. This ion implantation is then annealed to form source/drain regions 84, as shown in Figure 14A. Masking layer 80 is formed as shown in Figure 14B to allow for the formation of N+ region 184 during the ion implantation step described with regard to Figure 14A.

Etch mask 80 is then removed and a second etch mask 86 is formed as shown in Figure 15A. Etch mask 86 is then patterned using common photolithographic techniques to provide the structure for etch mask 86 as shown in Figure 15A. The structure of Figure 15A is then subjected to an ion implantation of boron ions having an energy of approximately 20 kiloelectron volts and a density of approximately $3 \times 10^{15}$ ions/$cm^2$. This forms P+ source/drain regions 90 and base contact regions 92 as shown in Figure 15A. Mask 86 is formed as shown in Figure 15B to allow for the implantation of P type dopant ions in the formation of P+ region 190 as shown in Figure 15B. This ion implantation is formed using the same step used to form P+ regions 90 and P+ regions 92 in Figure 15A. Contact is then made to polycrystalline silicon layer 170, N+ region 184 and P+ region 190 to provide the collector, emitter and base contacts, respectively, of NPN transistor 194.

Thus NPN transistor 194, NPN transistor 94, P channel transistor 96 and N channel transistor 98 are fabricated. Additional steps such as silicidation of the surfaces of emitter contact 68, gates 72 and 74, emitter region 184, collector contacts 58 and 158 source/drain regions 84, source/drain regions 90, and base contact regions 92 and 190 may be performed to provide better conductivity for the resulting structure.

Another embodiment of the invention illustrated in Figure 16. In Figure 16, Collector contact region 158 is formed so that it horizontally surrounds P well 148. This structure is fully isolated from other devices in the integrated circuit by the NP junction between the N+ buried collector 116 and Collector contact 158 and the P type epitaxial layer and substrate.

In order to provide a more compact layout for the bipolar transistor, a trench isolation scheme may be utilized. The processing steps for forming this trench isolation scheme are shown in Figures 17A through 17E.

Trench 210 are formed through P region 148 to expose buried N+ region 116. Components in the structures of Figure 17A having like numbers to previously described structures correspond to those previously described structures. the trench may be formed using known trench etching techniques such as that described in Douglas, U.S. Patent No. 4,784,720, issued November 15, 1988 and assigned to the assignee of this application. Trench 210 surrounds P well 148, thus isolating the to-be-formed transistor from other active devices in a similar manner to the structure of Figure 16. Silicon dioxide layer layer 212 is then formed on the structure of Figure 17A using low pressure chemical vapor deposition or thermal oxidation. The structure of Figure 17B is subjected to an anisotropic etching process such as reactive ion etching in sulfur exfluoride to provide side wall oxide layers 214 as shown in Figure 17C. A highly doped polycrystalline silicon layer 216 is formed on the surface of Figure 17C using low pressure chemical vapor deposition and an in situ doping. Polycrystalline silicon layer 216 is then etched back in a planar manner to leave remaining polycrystalline silicon plugs 218 as shown in Figure 17D. Using the processing steps described with regard to Figures 12B through 15B, N+ regions 184, P_| region 190, silicon dioxide layer 150 and polycrystalline layer 174 are formed. Thus, a bipolar transistor is fabricated using thin silicon dioxide layers 214 as isolation regions as opposed to the thick and wide silicon dioxide layers 154 in Figure 15B. Therefore, the structure of Figure 17E requires less area on the integrated circuit.

Although specific embodiments of the present invention are herein described, they are not to be construed as limiting the scope of the invention. For example, although the described embodiments show the use of silicon based devices, other suitable materials such as Gallium Arsenide my advantageously use the invention. The scope of the invention is limited only by the scope of the claims appended hereto.

## TECHNICAL ADVANTAGES

The described embodiments of the present invention provide a structures and methods for fabricating those structures in corporating bipolar transistors in the same integrated circuit as complementary metal-oxide-semiconductor transistors using a simpler process than those known in the art.

## Claims

1. A method for forming a bipolar transistor, comprising the steps of:
providing a substrate having a first conductivity type;
forming a buried doped region in said substrate having a second conductivity type opposite to said first conductive type, said buried region being spaced from a surface of said substrate;

forming a contact to said buried doped region;

forming and patterning a layer on said surface;

forming an emitter doped region in said substrate adjacent to said layer using said layer as a mask to prevent forming said emitter doped region under said patterned layer; and

forming a contact to said substrate adjacent to said layer.

2. The method of Claim 1 wherein the step of forming said contact to said buried region comprises the steps of:

forming a contact doped region extending from said surface to said buried doped region; and

forming a conductor in ohmic contact with said contact doped region.

3. The method of Claim 1 wherein said step of forming a contact to said substrate comprises the steps of:

forming a contact doped region having said first conductivity type in said substrate using said layer as a mask; and

forming a conductor in ohmic contact with said contact doped region.

4. The method of Claim 1 wherein said substrate comprises crystalline silicon.

5. The method of Claim 1 wherein said buried doped region is formed by the steps of:

implanting dopant ions into the surface of said substrate; and

forming an epitaxial layer on said substrate to extend the surface of said substrate above said buried doped region.

6. The method of Claim 1 wherein said emitter doped region is formed implanting dopant ions into said substrate using said layer as a mask.

7. The method of Claim 1 further comprising the step of forming sidewall masking layers on the sidewalls of said layer.

8. The method of Claim 1 wherein said layer comprises a conductive layer and said conductive layer is used for conductive connection and control in other devices in an integrated circuit containing said bipolar transistor.

9. A method for forming a bipolar transistor, comprising the steps of:

providing a substrate having a first conductivity type;

forming a buried doped region in said substrate having a second conductivity type opposite to said first conductive type, said buried region being spaced from a surface of said substrate;

forming a trench from said surface to said buried doped region;

forming sidewall insulating layers on the sidewalls of said trench;

filling said trench with a conductive material;

forming and patterning a layer on said surface;

forming an emitter doped region in said substrate adjacent to said layer using said layer as a mask to prevent forming said emitter doped region under said patterned layer; and

forming a contact to said substrate adjacent to said layer.

10. The method of Claim 9 wherein said step of forming a contact to said substrate comprises the steps of:

forming a contact doped region having said first conductivity type in said substrate using said layer as a mask; and

forming a conductor in ohmic contact with said contact doped region.

11. The method of Claim 9 wherein said substrate comprises crystalline silicon.

12. The method of Claim 9 wherein said buried doped region is formed by the steps of:

implanting dopant ions into the surface of said substrate; and

forming an epitaxial layer on said substrate to extend the surface of said substrate above said buried doped region.

13. The method of Claim 9 wherein said emitter doped region is formed implanting dopant ions into said substrate using said layer as a mask.

14. The method of Claim 9 further comprising the step of forming sidewall masking layers on the sidewalls of said layer.

15. The method of Claim 9 wherein said layer comprises a conductive layer and said conductive layer is used for conductive connection and control in other devices in an integrated circuit containing said bipolar transistor.

16. A method for forming a bipolar transistor, comprising the steps of:

providing a substrate having a first conductivity type;

forming a buried doped region in said substrate having a second conductivity type opposite to said first conductive type, said buried region being spaced from a surface of said substrate;

forming thick silicon dioxide regions on said surface of said substrate, said thick silicon dioxide regions separating a collector contact area from a base/emitter contact area and separating said base/emitter contact area from adjacent active devices;

forming a contact to said buried doped region extending from said collector contact area to said buried doped region;

forming and patterning a layer on said surface on said base/emitter area;

forming an emitter doped region in said substrate adjacent to said layer using said layer as a mask to prevent forming said emitter doped region under said patterned layer; and

forming a contact to said substrate adjacent to said layer.

17. The method of Claim 16 wherein the step of forming said contact to said buried region comprises the steps of:

forming a contact doped region extending from said surface to said buried doped region; and

forming a conductor in ohmic contact with said contact doped region.

18. The method of Claim 16 wherein said step of forming a contact to said substrate comprises the steps of:

forming a contact doped region having said first conductivity type in said substrate using said layer as a mask; and

forming a conductor in ohmic contact with said contact doped region.

19. The method of Claim 16 wherein said substrate comprises crystalline silicon.

20. The method of Claim 16 wherein said buried doped region is formed by the steps of:

implanting dopant ions into the surface of said substrate; and

forming an epitaxial layer on said substrate to extend the surface of said substrate above said buried doped region.

21. The method of Claim 16 wherein said emitter doped region is formed implanting dopant ions into said substrate using said layer and said thick insulating layers as a mask.

22. The method of Claim 16 further comprising the step of forming sidewall masking layers on the sidewalls of said layer.

23. The method of Claim 16 wherein said layer comprises a conductive layer and said conductive layer is used for conductive connection and control in other devices in an integrated circuit containing said bipolar transistor.

24. The method of claim 16 wherein said thick insulating layers comprise silicon dioxide.

Fig. 1A PRIOR ART

Fig. 2A PRIOR ART

Fig. 3A PRIOR ART

Fig. 4A PRIOR ART

Fig. 5A PRIOR ART

Fig. 6A PRIOR ART

Fig. 7 PRIOR ART

Fig. 7B

9

*Fig. 8A* PRIOR ART

*Fig. 8B*

*Fig. 9A* PRIOR ART

*Fig. 9B*

Fig. 10A PRIOR ART

Fig. 11A PRIOR ART

Fig. 12A PRIOR ART

Fig. 12B

11

Fig. 13A    PRIOR ART

Fig. 13B

Fig. 14A    PRIOR ART

Fig. 14B

Fig. 15B

Fig. 16

Fig. 15A  PRIOR ART

Fig. 17A

Fig. 17B

Fig. 17C

Fig. 17D

Fig. 17E